Europäisches Patentamt

European Patent Office

Office européen des brevets

(19)

(11) Publication number: **0 171 111**
A2

# EUROPEAN PATENT APPLICATION

(12)

(21) Application number: **85201166.7**

(22) Date of filing: **11.07.85**

(51) Int. Cl.⁴: **G 03 F 7/02**

(30) Priority: **13.07.84 BE 2060459**

(43) Date of publication of application: **12.02.86**
**Bulletin 86/7**

(84) Designated Contracting States: **AT BE CH DE FR GB IT LI LU NL SE**

(71) Applicant: **BELL TELEPHONE MANUFACTURING COMPANY Naamloze Vennootschap, Francis Wellesplein 1, B-2018 Antwerp (BE)**

(84) Designated Contracting States: **BE LU NL**

(71) Applicant: **International Standard Electric Corporation, 320 Park Avenue, New York New York 10022 (US)**

(84) Designated Contracting States: **CH DE FR GB IT LI SE AT**

(72) Inventor: **Beernaert, Dirk Maurice, Perreveld 97, B-9660 Brakel (BE)**
Inventor: **Horre, Rudy Eddy, Batavialaan 61, B-8800 Roeselare (BE)**

(74) Representative: **Vermeersch, Robert et al, BELL TELEPHONE MANUFACTURING COMPANY Naamloze Vennootschap Patent Department Francis Wellesplein 1, B-2018 Antwerp (BE)**

(54) **Process to superpose two positive photoresist layers.**

(57) This process for superposing two positive photoresist layers on a semiconductor device includes the steps of forming a fluorine containing coating on a portion of the first positive resist layer, baking the thus obtained coated portion between 160°C and 250°C and for 10 to 30 minutes without modifying the properties of the first resist layer, and depositing the second positive resist layer on the thus hardened portion.

- 1 -

PROCESS TO SUPERPOSE TWO POSITIVE
PHOTORESIST LAYERS

The present invention relates to a process for depositing a second positive photoresist layer on a first positive photoresist layer provided on an article, e.g. an electronic chip.

Such a process is already known, e.g. from the article "High resolution trilevel resist" by H. Namatsu et al, Journal of Vacuum Science Technology , Vol. 21, No 2, July/August 1982, pp 672-676, published by the "American Institute of Physics".

While the superposition of two negative photoresist layers poses no problems, this is not the case with positive photoresist layers . However, such layers are preferred because they have a better photolythographic resolution. This is especially useful when the circuit density is relatively high.

In the above known process for depositing a positive resist layer over another positive resist layer, an intermediate layer is used to prevent the two layers from merging into each other. If no intermediate layer is used and if the first resist layer serves for planarizing the surface topography of the chip, the deposition of the second resist layer directly on top of the first one will destroy this planarization effect. Moreover, if the first resist layer is provided with a pattern the latter may be damaged by the deposition of the second resist layer. On the other hand, when portions of the chip are not protected by the first layer due to the

- 2 -

latter being provided with a pattern, an intermediate layer, e.g. silicon oxide, coating the whole chip may affect these chip portions. Indeed, this intermediate layer of silicon oxide must be deposited at a low temperature to prevent damaging the first resist layer and will therefore be of poor quality and contain impurities. These impurities are then able to contaminate the chip in the above mentioned portions. Since the intermediate layer has not the same properties as a photoresist layer, a pattern on the second resist layer can only be transmitted to the first resist layer by means of extra processing steps. Furthermore, the first resist layer can only be removed after the intermediate layer. This requires also extra processing steps.

An object of the present invention is to provide a process which allows the superposition of two positive photolythographic resist layers without any intermediate layer being required.

According to the invention, this object is achieved due to the fact that said process consists in hardening at least a portion of said first layer prior to depositing said second layer directly on said portion.

By hardening the first resist layer, the merging with the second resist layer is prevented. Moreover, a pattern on the second resist layer can be immediately transferred to the first resist layer and the latter can be removed together with the second resist layer without any extra processing step.

The invention also relates to a semiconductor device made in accordance with the above process.

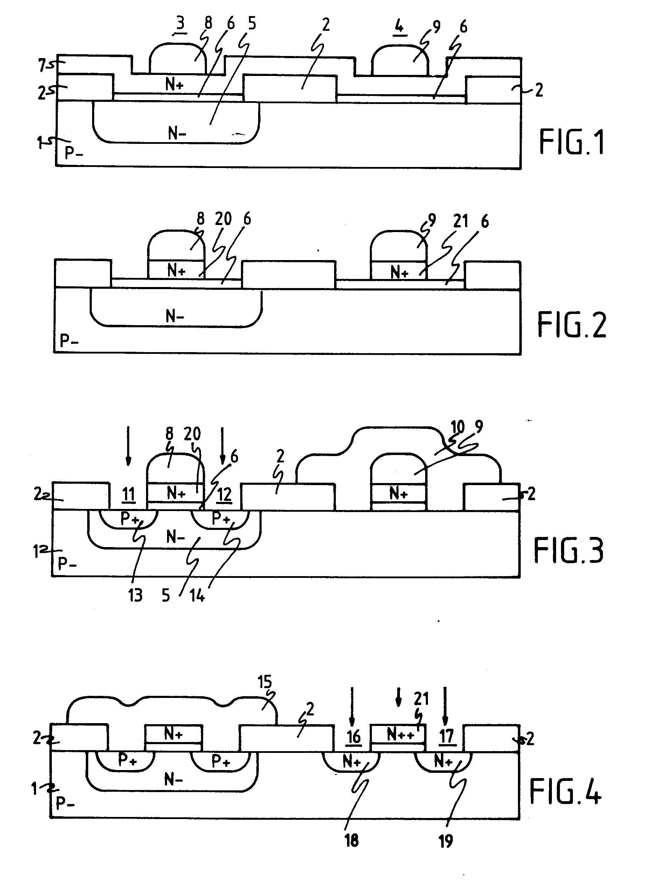

The above mentioned and other objects and features of the invention will become more apparent and the invention itself will be best understood by referring to the following description of an embodiment taken in conjunction with the accompanying drawings wherein Figs. 1 to 4 show successive main steps of a part of a process for making a semiconductor device according to the invention, the constituent parts of this device being not

- 3 -

drawn at scale.

This semiconductor device includes a P-channel and a N-channel MOS transistors represented at the left and right hand sides of the figures respectively.

The semiconductor device represented in Fig. 1 is obtained as follows. On a chip constituted by a P⁻ substrate 1, i.e. a slightly doped P substrate, a field silicon oxide layer 2 is grown. By means of a mask (not shown) and a classical photolythographic process this layer 2 is removed from the substrate 1 in the windows 3 and 4. Also by means of a photolythographic process, the window 4 is covered by a new mask (not shown) and a thin layer of a slightly doped N material (phosphorus) is implanted under the unprotected portion of the substrate 1 in window 3. To be noted that during this implantation operation also the unprotected parts of the field silicon oxide layer 2 are used as a mask to ensure that the N material is only implanted under the substrate surface in the window 3 and in the whole surface of this window. After the mask has been removed, the thin layer of N material is driven in the substrate 1 by a diffusion drive-in operation so that a slightly doped so-called N⁻ well 5 which extends laterally under the field oxide layer 2 surrounding the window 3 is obtained. A gate silicon oxide 6 is then grown on the upper surface of the substrate 1 especially in the windows 3 and 4. After this operation, a negatively doped (N⁺) layer of polysilicon material 7 is deposited on top of the oxide layers 2 and 6. Finally, by a photolythographic process, so-called gate masks 8 and 9 made of a positive photoresist material are formed on the gate portions 20 and 21 (Fig. 2) of the layer 7 to protect these gate portions during a subsequent etching operation by which the unprotected other portions of the polysilicon layer 7 are removed, as represented in Fig. 2.

All the above steps of the process will not be described more in detail since they are known from the art

- 4 -

and are of less importance for the present invention.

The etching operation of the polysilicon layer 7 makes use of a fluorine containing plasma (not shown) as a consequence of which a fluorine containing coating is formed on the masks 8 and 9. The thus coated gate masks 8 and 9 are then hardened by baking the chip at a temperature of 200 degrees centigrade during 30 minutes. The fluorine containing coating is then removed from the chip since a resist layer used in a subsequent operation cannot adhere to it. The removal of the coating is performed by a so-called flash-strip operation wherein the chip is brought in a 150 Watt oxygen containing plasma during 2 minutes. The flash-strip operation also protects the chip against wetting. Finally, the portions of the gate silicon oxide layer 6 which are not protected by the gate masks 8 and 9 are removed.

Reference is now made to Fig. 3 where a $P^+$ positive photoresist mask 10 is formed on the gate mask 9. The mask 10 is obtained by a classical process which consists of depositing a positive photoresist material on the whole chip and by removing the unwanted portions by means of a photolytographic mask. Because of its hardening, the underlying positive photoresist mask 8 is not removed by the above mentioned operations.

An ion implantation schematically indicated by the arrows pointing to the windows 11 and 12 is then performed. It produces thin layers of P material under the upper surface of the substrate 1 in these windows. To be noted that during this implantation operation also the field silicon oxide layer 2 is used as a mask to ensure that P material is only implanted under the substrate surface in the windows 11 and 12 and in the whole surface of these windows. This is the reason why the mask 10 should not extend in the lateral direction beyond the layer 2.

The photoresist mask 8 and the second photoresist mask 10 are used together to realize the self-alignment and to protect the gate portion 20 against an ion bombardment. Indeed, as it appears clearly from Figs. 2 and 3 the gate mask 8 used for the etching operations of the polysilicon layer 20 and of the gate silicon oxide layer 6 is also used for the P ions implantation so that all these operations are performed in a so-called self-aligned way and in accurately the same windows 11 and 12. Furthermore, the hardened mask 8 provides a better protection of the $N^+$ polysilicon layer 20 against the P ions (boron) during the implantation operation.

The P material implanted in the windows 11 and 12 is then driven in the $N^-$ well 5 by a diffusion drive-in operation similar to the one described above. As a result, there are obtained two $P^+$ regions 13 and 14 which extend laterally under both the field 2 and the gate 6 oxide layers. These two regions 13 and 14 constitute the drain and source electrodes of a P-channel MOS transistor whose gate electrode is the $N^+$ polysilicon layer 20.

After a P-channel MOS transistor has thus been made all the photoresist layers 8, 9 and 10 are removed from the chip.

Reference is now made to Fig. 4 which shows how a N-channel MOS transistor is made. A $N^+$ mask 15 is first deposited on the P-channel MOS transistor to protect the latter against N material implantation. This implantation operation of N material (phosphorus) schematically indicated by arrows pointing to the windows 16 and 17 produces thin layers of this material under the upper surface of the substrate 1 in these windows. To be noted that during this implantation operation also the field silicon oxide layer 2 and the polysilicon layer 21 are used as masks to ensure that the N material is only implanted under the substrate surface in the windows 16 and 17 and in the whole surface of these windows. For this reason, the mask 15 should not extend in the lateral direction beyond the layer 2.

- 6 -

Since the polysilicon layer 21 was already negatively doped ($N^+$), there is no need to protect it against the N material implantation. The only consequence of such an additional bombardment of negative ions onto the polysilicon layer 21 is that its doping will increase. This is schematically indicated by $N^{++}$ in Fig. 4. Because the polysilicon layer 21 constitutes the gate electrode of a N-channel MOS transistor, the degree of doping of this layer, as long as it remains in an acceptable range, is of less importance for the operation of this transistor. The drain and source electrodes of the above mentioned N-channel MOS transistor are the $N^+$ regions 18 and 19 obtained by a diffusion drive-in operation of the implanted N material in the $P^-$ substrate 1. This diffusion operation is similar to the one described above.

The photoresist layer 15 is then removed and the process for making the two MOS transistors may be completed in a classical way.

While the principles of the invention have been described above in connection with specific apparatus, it is to be clearly understood that this description is made only by way of example and not as a limitation on the scope of the invention.

0171111

- 7 -

CLAIMS

1) Process for depositing a second positive photoresist layer (10) on a first positive photoresist layer (8, 9)
provided on an article, e.g. an electronic chip,
characterized in that said process consists in hardening
at least a portion of said first layer (8, 9) prior to
depositing said second layer (10) directly on said portion.

2) Process according to claim 1, characterized in
that said first (8,9) and second (10) resists are substantially identical.

3) Process according to claim 1, characterized
in that said hardening is realized by making use of a fluorine
containing plasma.

4) Process according to claim 3, characterized
in that said fluorine containing plasma is transformed into
a fluorine containing coating covering at least said portion
of said first resist layer (8, 9).

5) Process according to claim 4, characterized
in that said hardening is realized by baking said coated
first resist layer (8, 9) at a predetermined temperature
ranging from      160  to 250 degrees centigrade and during
a predetermined time ranging  from  10  to 30 minutes.

6) Process according to claim 5, characterized
in that after said hardening said fluorine containing
coating is removed from at least said portion of said first
resist layer (8, 9) by means of an oxygen containing plasma.

7) Process according to claim 1, characterized

0171111

- 8 -

in that said first resist layer (8, 9) is provided with a
pattern.

8) Process according to claim 7, characterized
in that said hardening is realized after the production of
said pattern in said first resist layer (8, 9).

9) Process according to claim 1, characterized
in that said second resist layer (10) is provided with
a pattern.

10) Semiconductor device, characterized in that it is
made in accordance with the process of any of the preceding
claims.

11) Semiconductor device according to claim 10,
characterized in that it includes at least one MOS transistor.

0171111

FIG.1

FIG.2

FIG.3

FIG.4